**Europäisches Patentamt**

**European Patent Office**

**Office européen des brevets**

(11) Publication number : **0 389 264 B1**

(12) **EUROPEAN PATENT SPECIFICATION**

(45) Date of publication of patent specification :
31.05.95 Bulletin 95/22

(21) Application number : **90303045.0**

(22) Date of filing : **21.03.90**

(51) Int. Cl.⁶ : **H01J 37/153**

(54) Ion implantation apparatus.

(30) Priority : **22.03.89 JP 69915/89**
**20.02.90 JP 40595/90**

(43) Date of publication of application :
**26.09.90 Bulletin 90/39**

(45) Publication of the grant of the patent :
**31.05.95 Bulletin 95/22**

(84) Designated Contracting States :
**DE GB**

(56) References cited :
**EP-A- 0 175 933**
**GB-A- 2 095 895**

(73) Proprietor : **NIHON SHINKU GIJUTSU**
**KABUSHIKI KAISHA**
**2500, Hagizono**
**Chigasaki-shi Kanagawa-ken (JP)**

(72) Inventor : **Sakurada, Yuzo**
**521-3 Ninomiya,**
**Nimomiya-cho**
**Naka-gun, Kanagawa-ken (JP)**
Inventor : **Tsukakoshi, Osamu**
**547-42 Sanada**
**Hiratsuka-shi, Kanagawa-ken (JP)**

(74) Representative : **Cross, Rupert Edward Blount**
**et al**
**BOULT, WADE & TENNANT**
**27 Furnival Street**
**London EC4A 1PQ (GB)**

EP 0 389 264 B1

## Description

The present invention relates to an ion implantation apparatus intended for raster-scanning ion beams on a substrate to be ion implanted.

As well-known an ion implantation is utilized to perform an impurity doping or a material synthesization on a substrate by irradiating accelerated ions onto the surface thereof. The doping can be performed without any influence of the surface condition of the substrate and with very high accuracy and cleanliness. Therefore, the ion implantation may be utilized for manufacturing LSI elements, VLSI elements or the like, or synthesizing an alloy or an amorphous material.

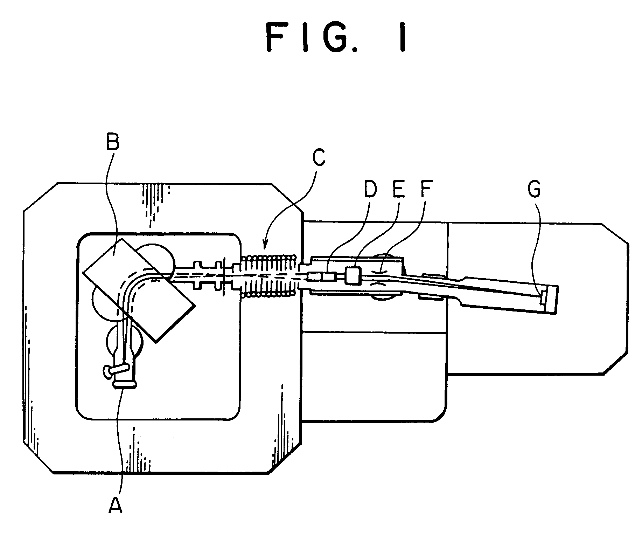

An example of a conventional ion implantation appara-tus is shown in Fig. 1 of the drawings. The apparatus shown in Fig. 1 comprises an ion source A for generating an ion beam, a mass separator B, an accelera-tor C, a converging lens system D, a parallel flat plate type electrostatic deflector E for deflecting the ion beam in Y direction (vertical direction), a parallel flat plate type electrostatic deflector F for deflecting the ion beam in X direction (horizontal direction), and a processing chamber which contains a substrate G to be ion implanted.

The ion beam generated by the ion source A is passed through the mass separator B by which ions having a predetermined kinetic energy and mass are selected from other ions produced in the ion source A. The ion beam containing ions selected by the mass separator B is accelerated by the accelerator C and then is converged by the converging lens system D.

In the parallel flat plate type electrostatic deflector E, the converged ion beam is swept in Y direction by applying voltage of a triangular wave of for example 176 Hz thereto. In the parallel flat plate type electrostatic deflector F, the ion beam is deflected by applying voltage for offsetting of approximately 7° in X direction and simultaneously is swept in X direction by applying voltage of a triangular having, for example, 833 Hz.

With the conventional ion implanting apparatus, as mentioned above, after being swept in Y direction by means of the parallel flat plate type electrostatic deflector E, the ion beam is subjected to the offset-deflection in X direction and the sweeping-deflection in X direction simultaneously in the parallel flat plate type electrostatic deflector F. However, since the ion beam is raster-scanned in X and Y directions and thus the ion beam appeared on the outlet of the deflec-tor F does not have a constant direction, the ion beam is to be incident on the substrate G with different incidence from point to point.

If the diameter of the substrate is for example 15cm (6 inch), the difference of 2.7° in an implantation angle of incidence may occur between the ion beam incident on the periphery portion of the substrate and the ion beam incident on the center portion thereof. Also, with the substrate having a diameter of 20 cm (8 inch), the difference in angle of incidence between the ion beam incident on the periphery portion and the ion beam incident on the center portion becomes 3.6°. Between the opposite ege portions of the 15 cm (6-inch) substrate there may occur the difference in angle of incidence 2.7° x 2 = 5.4°. For 26 cm (8-inch) substrate 3.6°x 2 = 7.2°.

This results in that the ion implantating condition to be performed on the substrate or wafer is different from point to point on the substrate or wafer. This phenomenon causes a shadowing effect in the ion implantation in fabricating IC elements trench constructions. Further, the uniformity of the ion implantation is deteriorated at the periphery portion of the substrate where the solid angle of the ion beam cut by the unit area of the substrate diminishes, also feasibly causing channeling at the periphery portion.

On the other hand, as the microfabrication of the substrate progresses and the pattern line width decreases, the shadowing effect in ion implantation has an unfavourable influence on the processing of the substrate. For a CMOS DRAM having 4 M bits memory or more, thus, it is necessary to ion implant the whole surface of the substrate with an ion beam pointed parallel to a definitely predetermined direction. More specifically, as the substrate size is increased from 15 to 20 cm (6 to 8 inches) and the memory size of the DRAMs increases to 4M or further 16M bits, and thus the pattern width is reduced, the need of parallel ion beam implantation has become to be closed-up.

An ion implantation apparatus having a first multipole electrostatic deflector disposed around an optical axis for sweeping an ion beam in X and Y directions, and a second multipole electrostatic deflector arranged to receive the swept ion beam is disclosed in an article by Sturans et al (J. of Vacuum Science and Technolo-gy/Section B 6 (1988) Nov/Dec., No 6, New York, U.S.A., pages 1995-1998). Although this arrangement provides for the swept ion beam to have a constant angle of incidence on a target it does not eliminate the possibility of neutral particles produced from high energy ions by a charge exchange with atoms of residual gases impinging on the target.

It is, therefore, an object of the present invention to work towards overcoming the problems involved in the conventional ion implantation apparatus.

An object of the present invention is to provide an ion implantation apparatus which is capable of being incident an ion beam to all over a substrate at a constant incident angle without any deterioration of the characteristic thereof.

Another object of the present invention is to provide an ion implantation appratus in which a deflector/scanner system can be simplified.

Another object of the present invention is to provide an ion implanter apparatus which is capable of providing a parallel scanning ion implantation of a substrate regardless of the size thereof.

A further object of the present invention is to eliminate any concentration of neutral particles produced from high energy ions by a charge exchange with atoms of residual gases at any local spot on the substrate which would deteriorate the uniformity of the doping seriously.

According to the present invention, there is provided an ion implantation apparatus comprising a first multipole electrostatic deflector disposed around an optical axis for sweeping an ion beam in x and y directions; and a second multipole electrostatic deflector arranged to receive the swept ion beam and point the ion-beam so as to have a constant angle at every spot on a substrate to be raster-scanned and ion-implanted; characterised in that said first multipole electrostatic deflector is adapted to simultaneously offset-deflect the ion beam at a predetermined angle; in that said second multipole electrostatic deflector is disposed around a second optical axis starting from the center of said first multipole electrostatic deflector and directed towards a line which makes said predetermined angle with the axis of said first multipole electrostatic deflector; and in that said second multipole electrostatic deflector is adapted to sweep and point the ion beam transmitted from the first multipole electrostatic deflector in a direction parallel with the second optical axis so as to have a constant angle at every spot on said substrate to be raster-scanned and ion-implanted.

The first multipole electrostatic deflector comprises five or more electrodes equally spaced around the first optical axis to each of which voltage for offset deflecting the ion beam at the predetermined angle and voltage for sweeping the ion beam in X and Y directions are applied in a superimposed state.

The second multiple pole electrostatic deflector comprises the same number of electrodes as the first deflector equally spaced around the second optical axis starting from the center of the first multipole electrostatic deflector and directed towards the line which makes the predetermined angle with the axis of the first multipole electrostatic deflector, to each of which voltage for sweeping the ion beam simulatneously in X and Y directions are applied so that the ion beam to be incident on a substrate has always a constant direction and angle with the surface of the substrate to be raster-scanned.

In the preferred embodiment of the present invention, each of the first and second multiple pole electrostatic deflectors is an octapole electrostatic deflector.

The ion beam is generated by an ion source and is fed into a mass separator by which only ions having the same mass number are selected. The ion beam containing ions thus selected is accelerated by an accelerator and converged by a converging lens.

In the ion implantation apparatus according to the present invention, the offset-deflecting voltage and the sweeping voltage may be in the superimposed state applied to each of the electrodes in the first multiple pole electrostatic deflector, and the sweeping voltage having a similar waveform to that of the multiple pole deflecting voltage and in phase therewith may be applied to the corresponding electrode of the second multiple pole electrostatic deflector. Therefore, the angle of incidence of the ion beam to be introduced into the substrate can be maintained at a constant to avoid any deterioration of the characteristic of the substrate.

The invention will now be described, by way of example, with reference to the accompanying drawings:

Fig. 1 is a schematic view of a conventional ion implantation apparatus;

Fig. 2 is a schematic view showing an embodiment of the present invention;

Fig. 3 is an enlarged perspective view showing the multipole electrostatic deflectors in the apparatus of Fig. 2;

Fig. 4 is an explanatory view how the voltage is applied to a cylindrical electrostatic deflector;

Fig. 5 is an explanatory view showing an electric field and voltages to be applied to the deflector;

Fig. 6 is a schematic diagram showing how electrodes in the first multiple pole electrostatic deflector are arranged and voltages are applied thereto;

Fig. 7 is a schematic diagram showing how electrodes in the second multiple pole electrostatic deflector are arranged and voltages are applied thereto;

Fig. 8 is an explanatory view showing an example how the octagonal scanning region is scanned;

Figs. 9 and 10 are explanatory views of a principle of the deflection on parallel sweeping in the first and second multiple pole electrostatic deflectors;

Fig. 11 is an explanatory view showing the velocity vectors of the ion beam on the outlet of the first multiple pole electrostatic deflector;

Figs. 12 to 14 is a schematic diagrams showing equipotential lines inside the cross section of an octapole electrostatic deflector obtained by a computer simulation for different deflection directions.

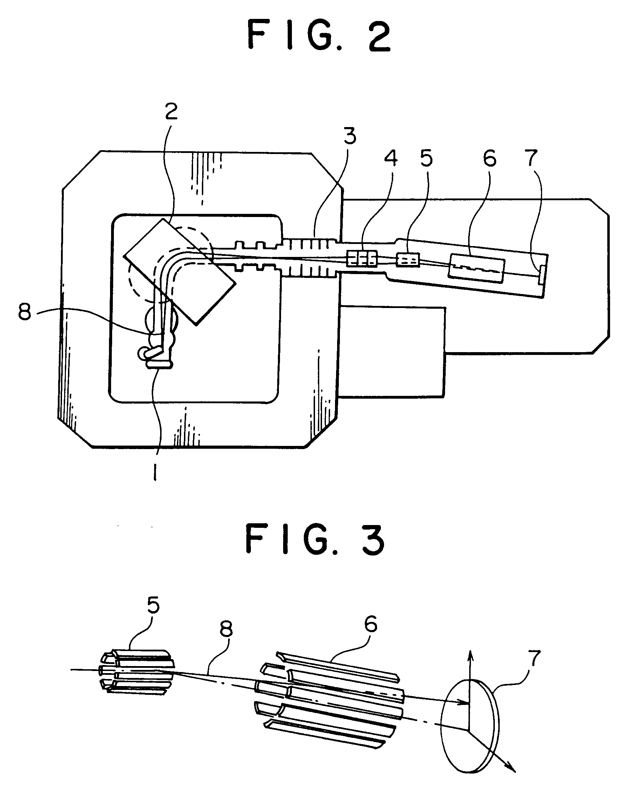

With reference to Fig. 2 of the drawings there is shown a whole construction of an ion implantation apparatus according to an embodiment of the present invention.

In Fig. 2, reference numeral 1 designates an ion source, reference numeral 2 designates a mass separator for separating only ions having the same mass number from other ions produced by the ion source 1, reference numeral 3 an accelerator for accelerating the ion beam including the separated ions having the same mass number, reference numeral 4 a converging lens for converging the ion beam accelerated by the accelerator 3, reference numeral 5 a first octapole electrostatic deflector for offset deflecting the ion beam converged by the converging lens 4 at a predetermined angle, for example, 7° and for sweeping the ion beam simultaneously in X direction (a horizontal direction) and Y direction (a vertical direction), and reference numeral 6 a second octapole electrostatic deflector which is disposed on the axis of the 7° offset-deflected ion beam at the rear of the first octapole electrostatic deflector 5 and has a size larger than that of the first deflector 5. The second octapole electrostatic deflector 6 is intended to sweep the ion beam deflected by the first octapole electrostatic deflector 5 in X direction (a horizontal direction) and Y direction (a vertical direction) so that the ion beam which appears on the outlet of the second octapole deflector 6 has constantly a predetermined direction and angle with respect to a substrate 7 onto which the ion beam is to be implanted. The ion beam is generally designated by reference numeral 8.

As will be seen in Fig. 2, the first and second octapole electrostatic deflectors 5 and 6 comprise elongated eight electrodes, respectively.

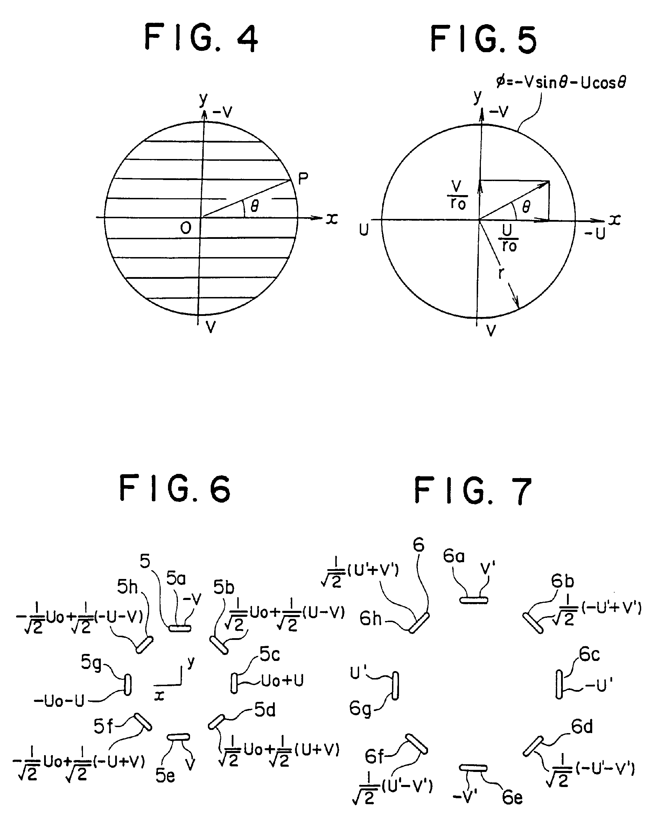

With reference to Figs. 3 and 4, it will be described how and what voltages are to be applied to the respective electrodes of the first and second deflectors. In Figs. 3 and 4, it is assumed that a deflector has a cylindrical section to the periphery of which potentials are applied.

It will now be explained what voltages are to be applied to the periphery of the cylindrical section in order to generate a uniform electric field V/ro in a y-axis direction.

Considering the radius OP forming an angle $\theta$ with respect to the x-axis direction, the following relation may be provided.

$$\phi = -V/ro \cdot ro \sin\theta = -V \sin\theta$$

where $\phi$ is the potential on the point P. More specifically, when the potential as designated by $-V \sin\theta$ is given to the periphery of the deflector, a uniform electric field V/ro may be formed in the y-axis direction in the cylindrical deflector. Similarly, when the potential $-U \cos\theta$ is given to the periphery of the deflector, a uniform electric field U/ro may be formed in the x-axis direction in the cylindrical deflector.

Then, if the potential distribution such as $-V \sin\theta - U \cos\theta$ is given to the periphery of the deflector as shown in Fig. 4, there may be obtained a uniform electric field E1 which consists of the superimposed y-axis direction field component V/ro and x-axis direction field component U/ro.

Upon the consideration mentioned above, it is possible to determine how and what voltages should be applied to the respective electrodes of the first and second octapole deflector 5 and 6.

As shown in Fig. 6, the first octapole electrostatic deflectors 5 comprises eight electrodes 5a to 5h which are circularly arranged around an optical axis so that they are equally spaced one another. Therefore, the voltages for offset-deflecting the ion beam 8 at the predetermined angle in the x-axis (-U) direction with respect to the optical axis, for example 7° may be so determined that 0 is applied to the electrode 5a, $1/\sqrt{2} \times U_0$ is applied to the electrode 5b, Uo to electrode 5c, $1/\sqrt{2} \times$ Uo to the electrode 5d, 0 to the electrode 5e, $-(1/\sqrt{2}) \times$ Uo to the electrode 5f, $-$ Uo to electrode 5g, and $-(1/\sqrt{2}) \times$ Uo to the electrode 5h.

The voltages for sweeping the ion beam 8 simultaneously in the x-axis direction or horizontal direction and y-axis direction or the vertical direction simultaneously may be so determined that $-$ V is applied to the electrode 5a, $(1/\sqrt{2}) \times$ (U-V) is applied to the electrode 5b, U to electrode 5c, $(1/\sqrt{2}) \times$ (U+V) to the electrode 5d, V to the electrode 5e, $(1/\sqrt{2}) \times$ (-U+V) to the electrode 5f, $-$ U to electrode 5g, and $(1/\sqrt{2}) \times$ (-U-V) to the electrode 5h. As shown in Fig.6, these sweeping voltages are superimposed on the deflecting voltages, respectively.

Also, as will be seen in Fig.7, the second octapole deflector 6 comprises eight electrodes 6a to 6h which are circularly arranged so that they are equally spaced one another. The second octapole deflector 6 has no function to offset-deflect the ion beam 8, and is intended only to sweep the ion beam 8 simultaneously in the x'-axis direction or horizontal direction and y'-axis direction or the vertical direction with respect to the second optical axis starting from the center of the first octapole deflector 5 and directed towards the line which makes the predetermined angle with the axis of the first octapole deflector 5. The voltages to be applied to the respective electrodes 6a to 6h may be determined as illustrated in Fig. 7. That is, V' is applied to the electrode 6a, $(1/\sqrt{2}) \times$ (-U'+V') is applied to the electrode 6b, $-$ U' to electrode 6c, $(1/\sqrt{2}) \times$ (-U'-V') to the electrode 6d, $-$ V' to the electrode 6e, $(1/\sqrt{2}) \times$ (U'-V') to the electrode 6f, U' to electrode 6g, and $(1/\sqrt{2}) \times$ (U'+V') to the electrode 6h.

Uo is the voltage for offset-deflection and thus constant, and U, V, U' and V' are voltages for the x-axis direction and y-axis direction sweeping and thus may be changed with time.

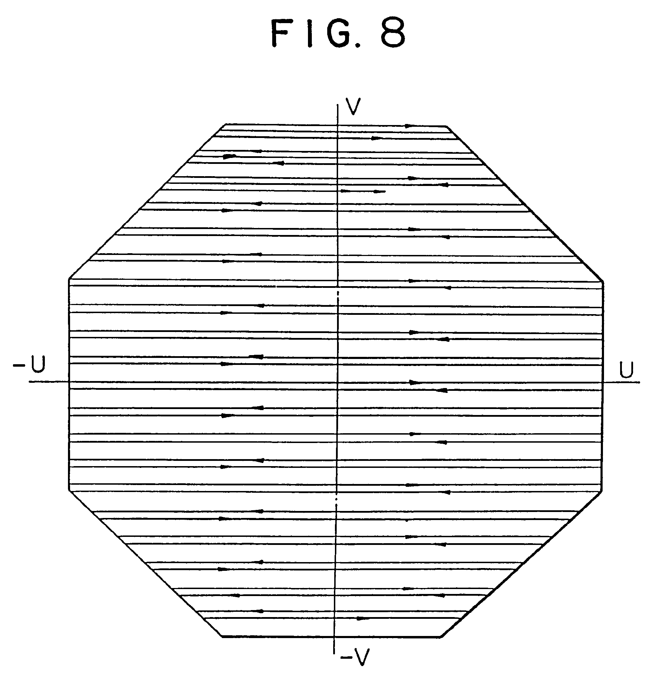

Fig. 8 shows a locus obtained when the substrate 7 was scanned by the ion beam 8 swept by the first and second octapole deflectors 5 and 6. A regular octagon circumscribed about the substrate is scanned in such a manner that the parallel ion beam scans downwards, upwards, downwards and so on the full scanning region at a constant speed along parallel lines drawn with a definite interval thereon, and in such a way as the successive scan traces along parallel lines displaced from the said preceding lines by one quarter, one third or half of the interval.

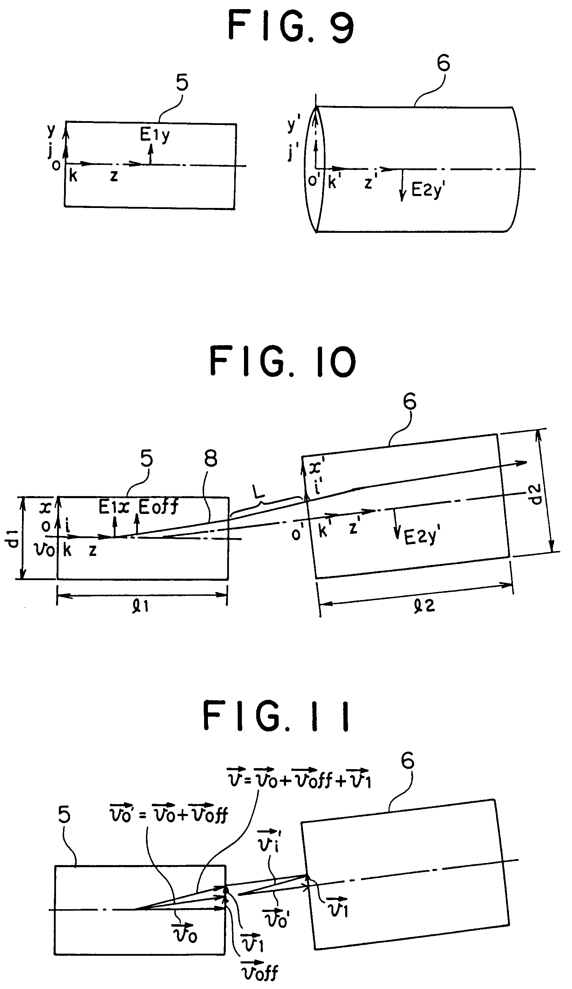

Then, the operation of the illustrated apparatus will be described with reference to Figs. 9, 10 and 11.

As shown in Figs. 9 and 10, it is assumed that the first octapole electrostatic deflector 5 has a diameter d1 and a length $\ell$1, the second octapole electrostatic deflector 6 has a diameter d2 and a length $\ell$2, the distance along the orbit of the ion beam between the first and second deflectors 5 and 6 is designated by L, an electric field generated by the offset-deflecting voltage applied to the respective electrodes in the first deflector 5 is designated by $\overrightarrow{Eoff}$ , an electric field generated by the sweeping voltage in the first deflector 5 is designated by $\overrightarrow{E1}$ , and an electric field generated by the sweeping voltage in the second deflector 6 is designated by $\overrightarrow{E2}$ . Also, the direction of the center axis of the first octapole deflector 5 which is set to correspond to the direction of the ion beam entered into the first octapole deflector 5 is defined as z-axis, the direction of the electric field $\overrightarrow{Eoff}$ for the offset-deflecting in the first deflector 5 is defined as x-axis, and y-axis is placed perpendicular to the z-axis and x-axis, thereby forming cartesian coordinates o - xyz. Similarly, the direction of the center axis of the second octapole deflector 6 which is set to correspond to the direction of the ion beam entered into the second octapole deflector 6 is defined as z'-axis, y'-axis is taken parallel with the y-axis, and x'-axis is taken perpendicular to the z'-axis and y'-axis, thereby forming cartesian coordinates o' -x'y'z'. The z'-axis corresponds to an axis starting from the center of the first deflector 5 and directed towards the line which makes the predetermined angle (7°) with the axis of the first deflector 5.

The electric field has a vector which influences the ion beam within the first octapole deflector 5 is the sum of the vectors $\overrightarrow{Eoff}$ and $\overrightarrow{E1}$ . The sum of the vectors $\overrightarrow{Eoff}$ and $\overrightarrow{E1}$ has a direction perpendicular to the z-axis because the vectors $\overrightarrow{Eoff}$ and $\overrightarrow{E1}$ are perpendicular to the z-axis.

It is now assumed that the ions entered into the first octapole deflector 5 have an energy of uo eV, a velocity of vo m/s, a mass of m kg and an electric charge of e coulomb. There may be represented equations of motion of the ions within the first octapole deflector 5 with MKS system of units as follows:

$$1/2\ m\ v0^2 = e\ uo \quad (1)$$
$$m\ d^2x/dt^2 = e\ (Eoff + E1x) \quad (2)$$
$$m\ d^2y/dt^2 = e\ E1y \quad (3)$$
$$m\ d^2z/dt^2 = 0 \quad (4)$$

where E1x and E1y represent the x-component and y-component of $\overrightarrow{E1}$ , respectively.

Therefore, from the equation (4), there is obtained dz/dt = a constant = vo. The time t1 which is required to pass the ions through the first octapole deflector 5 is represented by $\ell$1/vo.

Assuming that the velocity components in the x-direction and the y-direction of the ion beam on the outlet of the second octapole deflector 6 are designated by (dx/dt)out and (dy/dt)out, respectively, by integrating the equations (2) and (3) with respect to the time "t" these velocity components may be represented as follows;

$$(dx/dt)out = \int_0^{t_1}(d^2x/dt^2)dt$$
$$= e/m\ (Eoff + E1x)\ \ell1/vo \quad (5)$$

$$(dy/dt)out = \int_0^{t_1}(d^2y/dt^2)dt$$
$$= e/m \cdot E1y\ \ell1/vo \quad (6)$$

Then, if there is only the electric field $\overrightarrow{Eoff}$ for the offset-deflection within the first octapole deflector 5, the ion beam on the outlet of the first octapole deflector 5 has a velocity vector $\overrightarrow{voff}$ perpendicular To the z-axis which is represented by the following equation:

$$\overrightarrow{voff} = e/m \cdot \overrightarrow{Eoff} \cdot \ell 1/vo \qquad (7)$$

If there is only the electric field E1 for the sweeping deflection within the first octapole deflector 5, the ion beam on the outlet of the first octapole deflector 5 has a velocity vector v1 perpendicular to the z-axis which is represented by the following equation:

$$\overrightarrow{v1} = e/m \cdot E1x \cdot \ell 1/vo \cdot i + e/m \cdot E1y \cdot \ell 1/vo \cdot j$$

$$= e/m \cdot \ell 1/vo \ (E1x \ i + E1y \cdot j)$$

$$= e/m \cdot \overrightarrow{E1} \cdot \ell 1/v0 \qquad (8)$$

where i and j are unit vectors in the directions of the x-axis and y-axis, respectively and the unit vector in the direction of the z-axis is represented by k in Fig. 9 and 10.

Therefore, if there are the electric field $\overrightarrow{Eoff}$ for the offset-deflection and the electric field $\overrightarrow{E1}$ for the sweeping deflection within the first octapole deflector 5, the ion beam on the outlet of the first octapole deflector 5 has a velocity vector $\overrightarrow{v}$ which is represented by the following equation:

$$\overrightarrow{v} = \overrightarrow{vo} + \overrightarrow{voff} + \overrightarrow{v1} \qquad (9)$$

where vo is the velocity vector of the ion beam incident on the first octapole deflector 5.

However, if only the electric field Eoff for offset deflecting the ion beam at 7° is applied to the first octapole deflector 5, as shown in Fig. 11, the velocity vector $\overrightarrow{vo}'$ of the ion beam on the outlet of the first octapole deflector is given by the following:

$$\overrightarrow{vo}' = \overrightarrow{vo} + \overrightarrow{voff} \qquad (10)$$

Also, the magnitude of the velocity vector $\overrightarrow{vo}'$ is as follows:

vo′ = vo/cos 7° = 1.00751 vo    (11)

Turning now to the second octapole deflector 6, since it has no influence of the electric field for the offset-deflection, the magnitude of the velocity vector vo′ is equal to the above case, that is, vo′ = 1.00751 vo. Therefore, the time Δt2′ which is required to pass the ions through the second octapole deflector 6 is represented by the following relation:

Δt2′ = ℓ2/vo′ = ℓ2/vo · cos 7° = ℓ2/vo 0.9925    (12)

To the second octapole deflector 6 is applied the x′-component E2x′ and the y′-component E2y′ of the electric field $\overrightarrow{E2}$ for sweeping the ion beam in such a manner that the following relations are satisfied.

E1x · ℓ1/vo = - E2x′ . ℓ2/vo′    (13)
E1y · ℓ1/vo = - E2y′ · ℓ2/vo′    (14)

That is, in Figs. 4 and 5, if the electrodes of the first and second deflectors 5 and 6 are similar in the configuration and the spacing, but are different only in the length, the power supply may be constructed so that V′ and U′ are selected to be equal to V and U, respectively, the voltages V′ and V, - V′ and - V, U′ and U, - U′ and - U, (1/√2) x (U′+V′), (1/√2) x (U+V) ---- are respectively supplied by a power source provided with the same signal source and amplifier having the same voltage gain, and the first octapole deflector 5 is supplied by a power source by which the offset voltages Uo, - Uo, (1/√2) x Uo, and - (1/√2) x Uo can be provided. Then, the conditions defined in the relations (13) and (14) may be satisfied if the the length ℓ2 of the second octapole deflector 6 can be selected so that the following equa-tions are obtained.

|E1| = λV/d1, |E2| = λV/d2
|E1|/|E2| = d2/d1
ℓ2/d2 = ℓ1/d1 (vo′/vo) = 1.00751 ℓ1/d1

These conditions are realized when the sections of the first and second octapole are geometrically similar to each other, namely the cross sectional shape of each electrode of the second octapole deflector 6 and spacing between the adjacent electrodes are made with a constant magnification scale of the first octapole deflector 5, and only the length ia a little elongated compared with the value of an exact proportion.

The ions within the second octapole deflector 6 may be represented by the following equations of motion with MKS system of units:

$$m\, d^2x'/dt^2 = e\, E2x' \quad (15)$$
$$m\, d^2y'/dt^2 = e\, E2y' \quad (16)$$
$$m\, d^2z'/dt^2 = 0 \quad (17)$$

When the ion beam offset-deflected through the first octapole deflector 5 enters into the second octapole deflector 6, the ion beam has an incident velocity vector $\overrightarrow{v'}_{in}$ given by the following relation:

$$\overrightarrow{v'}_{in} = \overrightarrow{vo} + \overrightarrow{voff} + \overrightarrow{v1} = \overrightarrow{vo'} + \overrightarrow{v1} \quad (18)$$

Since the component $\overrightarrow{vo'}$ is perpendicular to the x'-axis and y'-axis, the following relation may be obtained:

$$(dx'/dt)_{in} = (v1)_x'$$

The x-axis and x'-axis are in directions separated by 7°, and thus the following relation may be obtained:

$$(dx'/dt)_{in} = e/m \cdot E1x \cdot \ell 1/vo \cdot \cos 7° \quad (19)$$

Further, since the y-axis and y'-axis are placed parallel to each other, the following relations may be obtained:

$$(dy'/dt)_{in} = (v1)_y' = (v1)_y = e/m \cdot E1y \cdot \ell 1/vo \quad (dz'/dt)_{in} = |vo'| + (v1 \cdot k') \quad (20)$$
$$= |vo'| + e/m \cdot E1x \cdot \ell 1/vo \cdot \sin 7° \quad (21)$$

where $(v1 \cdot k')$ is a scalar product of the velocity vector $\overrightarrow{v1}$ and the unit vector k' in the,direction of the z'-axis.

The velocity components of the ion beam at the outlet of the second octapole deflector 6 may be obtained by integrating the relations (15), (16) and (17) with respect to the time t.
That is,

$$(dx'/dt)_{out} = e/m \cdot E1x \cdot \ell 1/vo \cdot \cos 7°$$
$$+ e/m \cdot E2x' \cdot \ell 2/vo'$$

From the relation (13), the following relations may be obtained:

$$(dx'/dt)_{out} = e/m \cdot E1x \cdot \ell 1/vo (\cos 7° - 1)$$
$$= e/m \cdot E1x \cdot \ell 1/vo (- 0.007453)$$
$$= v1x (- 0.007453) \quad (22)$$
$$(dy'/dt)_{out} = e/m \cdot E1y \cdot \ell 1/vo + e/m \cdot E2y' \cdot \ell 2/vo' = 0 \quad (23)$$
$$(dz'/dt)_{in} = |vo'| + |e/m \cdot E1x \cdot \ell 1/vo| \cdot \sin 7°$$
$$= |vo'| + v1x \cdot 0.1218 \quad (24)$$

Then, the following is the actual numeric values which may be calculated on the case that the illustrated apparatus is utilized to implant the ions onto a 15 cm (6-inch) wafer.

If the first octapole deflector is 10 cm in diameter and its length 36 cm, $E1x_{max} = 12.5KV/10cm$, $E1y = 0$, and uo = 200eV, there is obtained v1x/vo = 0.1125, and the angle θ2 which is made between the ion beam at the outlet of the second octapole deflector 6 and z'-axis becomes as follows:

$$\tan θ2 = (dx'/dt)/(dz'/dt)$$
$$= (- v1x \cdot 0.007453)/(1.00751vo + v1x \cdot 0.1218)$$
$$= (- 0.1125 \times 0.007453)/(1.00751 + 0.1125 \times 0.1218)$$
$$= - 0.000821$$
$$θ2 = - 0.047°$$

In the above case, $|E1|_{max} = 12.5KV/10cm$ is sufficient for raster scanning over the substrate with a margin of about 3cm around it. The maximum deviation from the exact parallelism of the incident ion beam is - 0.047° when the beam is deflected to the left or right side, while when the beam is deflected to the upper and lower direction there is no deviation from the exact parallelism even at the edge of a raster pattern, and the deviation from the exact parallelism is less than 0.047° at any point over the substrate.

It is, therefore, appreciated that a parallel ion beam having an error less than 0.05° can be obtained at the outlet of the second octapole deflector 6.

In the illustrated embodiments described above, octapole electrostatic deflectors are employed. It should, however, be understood that the number of the electrodes of each electrostatic deflector may be five or more and thus it is possible to use multiple pole electrostatic deflectors which comprise poles less than or more than eight poles.

Further, the ion beam may be swept on the substrate so that it draws a circular or polygonal locus.

According to the ion implantation apparatus of the present invention, as described above, since the first octapole deflector is arranged to offset deflect the ion beam at the predetermined angle and to sweep simultaneously in the x and y directions, and the second multiple pole electrostatic deflector is disposed around the axis of the deflected and swept ion beam from the first octa-pole deflector for sweeping the ion beam simultaneously in the x and y directions so that the ion beam has always a constant angle and direction with respect to the substrate to be ion implanted, the ion beam can be implanted onto the substrate with a constant incident angle all over the regions thereof, thereby avoiding any deterioration of the characteristic of the ion-implanted substrate.

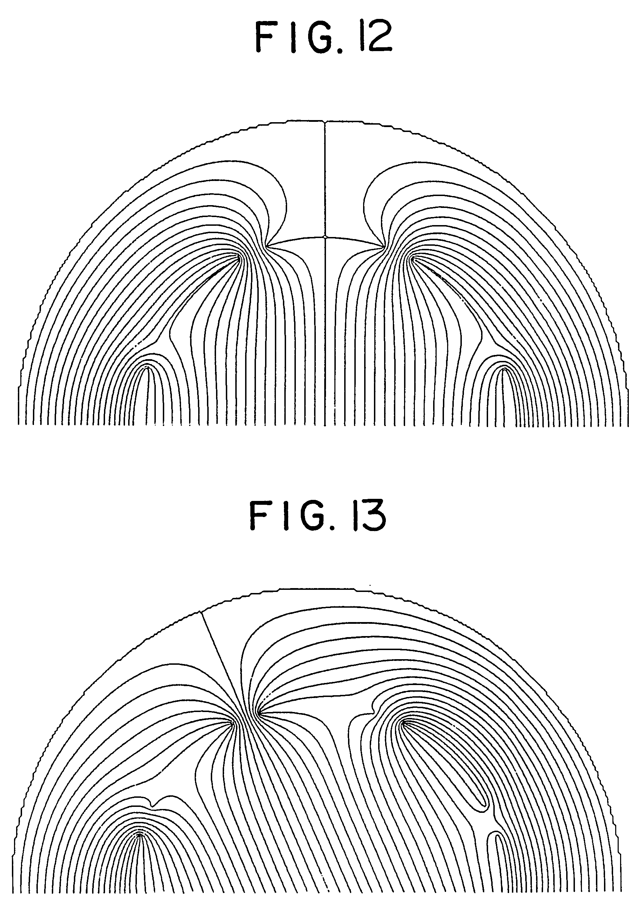

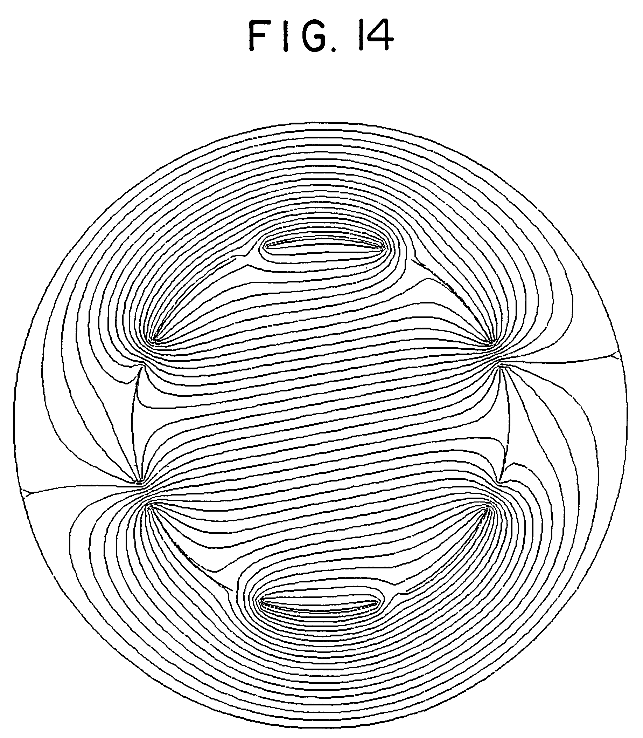

Further, with the provision of the multiple pole electrostatic deflectors, the effective range of the uniform electric field for sweeping can be widened as compared with the case of the conventional parallel flat plate electrostatic deflector, thereby reducing the size of the scanner to a realizable size so that the parallel beam ion implanter for 20 cm (8 inch) wafers has been designed with the overall length of 6.5 meters, while with conventional parallel plate type ion implanter the length of the apparatus for the parallel beam would surpass 10 meters. In Figs. 12 to 14 the distribution of the equipotential lines inside the cross section of the octapole electrostatic deflector are shown for different deflection directions which are obtained by a computer simulation. Fig. 12 shows the equipotential lines when the deflection is made in a direction of 25° with respect to the center axis of the deflector. Fig. 13 shows the equipotential lines with the deflection of 22.5°. Fig. 14 shows the equipotential lines with the deflection of 11.25°. In each case the result shows that an uniform electric field may be produced in the ara of about 70% of the diameter.

Moreover, the electric capacitance between the electrodes of the mulipole electrostatic deflector and the wall of a vaccum chamber is extremely small for instance about 10pF even for the second octapole deflector of the scanner for 20 cm (8 inch) wafers as the width of each electrode is narrow with the multipole electrostatic deflectors, while in the case of the parallel plate type scanner the electric capacitance of the electrode would surpass 150pF. The blunting and phase shift of the triangular wave form voltage depend on the quantity of FCR where F is the frequency of the triangular waves, C is the electric capacitance and R is the output impedance of a negative feed back high voltage power amplifier. It is only possible to manufacture the high speed, high precision and high voltage power amplifier for capacitive load less than 100pF by the present technology.

By offset-deflecting the ion beam by 7° simultaneously with the raster scanning deflection, it is possible to eliminate any concentration of neutral particles produced from high energy ions by a charge exchange with atoms of residual gases at any local spot on the substrate which would deteriorate the uniformity of the doping seriously.

The terms and expressions which have been employed herein are used as terms of description and not of limitation, and there is no intention, in the use of such terms and expressions, of excluding any equivalents of the features shown and described but it is recognized that various modifications are possible within the scope of the claims.

## Claims

1. An ion implantation apparatus comprising a first multipole electrostatic deflector (5) disposed around an optical axis for sweeping an ion beam (8) in x and y directions; and a second multipole electrostatic deflector (6) arranged to receive the swept ion beam (8) and point the ion-beam (8) so as to have a constant angle at every spot on a substrate (7) to be raster-scanned and ion-implanted; characterised in that said first multipole electrostatic deflector (5) is adapted to simultaneously offset-deflect the ion beam (8) at a predetermined angle; in that said second multipole electrostatic deflector (6) is disposed around a second optical axis starting from the center of said first multipole electrostatic deflector (5) and directed towards a line which makes said predetermined angle with the axis of said first multipole electrostatic deflector (5); and in that said second multipole electrostatic deflector (6) is adapted to sweep and point the ion beam (8) transmitted from the first multipole electrostatic deflector (5) in a direction parallel with the second optical axis so as to have a constant angle at every spot on said substrate (7) to be raster-scanned and ion-implanted.

2. An ion implantation apparatus as claimed in Claim 1, characterised in that said first multipole electrostatic deflector (5) comprises five or more electrodes (5a to h) equally spaced around the first optical axis to each of which voltages for deflecting the ion beam (8) at the predetermined angle and voltages for sweeping the ion beam (8) simultaneously in X and Y directions are applied in a superimposed state, and in that said second multipole electrostatic deflector (6) comprises the same number of electrodes (6a to h) as the first multipole electrostatic deflector (5), which electrodes are equally spaced around the second optical axis, and to each of which voltages for sweeping the ion beam (8) in X and Y directions are applied so that the ion beam (8) to be incident on a substrate (7) has always a constant direction and angle with respect to the substrate (7).

3. An ion implantation apparatus as claimed in Claim 1 or Claim 2, characterised in that each of said first and second multipole electrostatic deflectors (5, 6) is an octapole electrostatic deflector.

4. An ion implantation apparatus as claimed in any one of Claims 1 to 3, characterised by means to apply common sweeping voltages to the electrodes (5a to h, 6a to h) of said first and second multipole electrostatic deflectors (5, 6).

5. An ion implantation apparatus as claimed in any one of Claims 1 to 3, characterised by means to supply the sweeping voltages to be applied to the electrodes (5a to h, 6a to h) of said first and second multipole electrostatic deflectors (5, 6) by superimposing the sweeping voltages on the offset deflection voltages by coupling capacitors for the first multipole electrostatic deflector (5), and by feeding the same sweeping voltages directly to the electrodes (6a to h) of the second multipole electrostatic deflector (6).

6. An ion implantation apparatus as claimed in any one of Claims 1 to 3, characterised by means to supply the sweeping voltages to be applied to the electrodes (5a to h) of said first multipole electrostatic deflector (5) by adding the sweeping signal voltages to the offset deflection signal voltages and amplifying the synthesized signal voltages with the same voltage gain, and means to supply the sweeping voltages to be applied to the electrodes (6a to h) of said second multipole electrostatic deflector (6) by amplifying the same sweeping signal voltages with the same voltage gain.

## Patentansprüche

1. Ionenimplantationsvorrichtung mit einem um eine optische Achse angeordneten ersten elektrostatischen Multipoldeflektor (5) zum Rasterablenken eines Ionenstrahls (8) in x- und y-Richtung, und einem zweiten elektrostatischen Multipoldeflektor (6), der so angeordnet ist, daß er den rastergelenkten Ionenstrahl (8) empfängt und den Ionenstrahl (8) mit einem konstanten Winkel auf jeden Punkt auf einem Substrat (7), das abgerastert und ionenimplantiert werden soll, richtet, dadurch **gekennzeichnet**, daß der erste elektrostatische Multipoldeflektor (5) so eingerichtet ist, daß er den Ionenstrahl (8) gleichzeitig versetzt und in einem vorgegebenen Winkel ablenkt; daß der zweite elektrostatische Multipoldeflektor (6) um eine zweite optische Achse angeordnet ist, die vom Zentrum des ersten elektrostatischen Multipoldeflektors ausgeht und zu einer Linie gerichtet ist, die mit der Achse des ersten elektrostatischen Multipoldeflektors (5) den vorgegebenen Winkel einschließt; und daß der zweite elektrostatische Multipoldeflektor (6) so eingerichtet ist, daß er den von dem ersten elektrostatischen Multipoldeflektor (5) übertragenen Ionenstrahl (8) in einer Richtung parallel zur zweiten optischen Achse rasterablenkt und ausrichtet, so daß er einen konstanten Winkel an jedem Punkt des Substrats (7), das abgerastert und ionenimplantiert werden soll, hat.

2. Ionenimplantationsvorrichtung nach Anspruch 1,
dadurch **gekennzeichnet**, daß der erste elektrostatische Multipoldeflektor (5) fünf oder mehr Elektroden (5a bis h) aufweist, die in gleichen Abständen um die erste optische Achse angeordnet sind, und an davon mit überlagerte Spannungen zum Ablenken des Ionenstrahls (8) in dem vorgegebenen Winkel und Spannungen zum Rasterablenken des Ionenstrahls (8) gleichzeitig in x- und y-Richtung angelegt werden, und daß der zweite elektrostatische Multipoldeflektor (8) die gleiche Anzahl von Elektroden (6a bis h) wie der erste elektrostatische Multipoldeflektor (5) aufweist, die in gleichen Abständen um die zweite optische Achse herum angeordnet sind und jeder von ihnen Spannungen zum Rasterablenken des Ionenstrahls (8) in x- und y-Richtung derart zugeführt werden, daß der Ionenstrahl (8) bei seinem Auftreffen auf einem Substrat (7) immer konstante Richtung und Winkel relativ zum Substrat (7) hat.

3. Ionenimplantationsvorrichtung nach Anspruch 1 oder 2,
dadurch **gekennzeichnet**, daß der erste und zweite elektrostatische Multipoldeflektor (5, 6) ein elektrostatischer Oktapoldeflektor ist.

4. Ionenimplantantionsvorrichtung nach einem der Ansprüche 1 bis 3,
**gekennzeichnet** durch Mittel zum Anlegen von gemeinsamen Rasterablenkspannungen an die Elektroden (5a bis h, 6a bis h) des ersten und zweiten elektrostatischen Multipoldeflektors (5, 6).

5. Ionenimplantationsvorrichtung nach einem der Ansprüche 1 bis 3, **gekennzeichnet** durch Mittel zum Zuführen der an die Elektroden (5a bis h, 6a bis h) des ersten und zweiten elektrostatischen Multipoldeflektors (5, 6) anzulegenden Rasterablenkspannungen durch überlagern der Rasterablenkspannungen und der Versetzungs-Ablenkspannungen mittels Kopplungskondensatoren für den ersten elektrostatischen Multipoldeflektor (5) und durch Zuführen derselben Rasterablenkspannungen direkt zu den Elektroden (6a bis h) des zweiten elektrostatischen Multipoldeflektors (6).

6. Ionenimplantationsvorrichtung nach einem der Ansprüche 1 bis 3, **gekennzeichnet** durch Mittel zum Zuführen der an die Elektroden (5a bis h) des ersten elektrostatischen Multipoldeflektors (5) anzulegenden Rasterablenkspannungen durch Addieren der Rasterablenksignalspannungen zu den Versetzungs-Ablenksignalspannungen und Verstärken der synthetisierten Signalspannungen mit demselben Spannungsverstärkungsfaktor, und Mittel zum Zuführen der an die Elektroden (6a bis h) des zweiten elektrostatischen Multipoldeflektors (6) anzulegenden Rasterablenkspannungen durch Verstärken derselben Rasterablenksignalspannungen mit demselben Spannungsverstärkungsfaktor.

## Revendications

1. Appareil d'implantation d'ions, comprenant un premier déflecteur électrostatique multipolaire (5) disposé autour d'un axe optique afin qu'il balaye un faisceau d'ions (8) dans des directions x et y, et un second déflecteur électrostatique multipolaire (6) destiné à recevoir le faisceau d'ions balayé (8) et à diriger le faisceau d'ions (8) afin qu'il présente un angle constant en chaque point d'un substrat (7) destiné à subir un balayage par trame et une implantation d'ions, caractérisé en ce que le premier déflecteur électrostatique multipolaire (5) est destiné à assurer un décalage et une déviation simultanés du faisceau d'ions (8) suivant un angle prédéterminé, en ce que le second déflecteur électrostatique multipolaire (6) est placé autour d'un second axe optique à partir du centre du premier déflecteur électrostatique multipolaire (5) et est dirigé vers une droite qui forme l'angle prédéterminé avec l'axe du premier déflecteur électrostatique multipolaire (5), et en ce que le second déflecteur électrostatique multipolaire (6) est destiné à balayer le faisceau d'ions (8) transmis par le premier déflecteur électrostatique multipolaire (5) et à le diriger dans une direction parallèle au second axe optique de manière qu'il forme un angle constant en chaque point du substrat (7) qui subit le balayage par trame et l'implantation d'ions.

2. Appareil d'implantation d'ions selon la revendication 1, caractérisé en ce que le premier déflecteur électrostatique multipolaire (5) comporte au moins cinq électrodes (5a à 5h) régulièrement espacées autour du premier axe optique et à chacune desquelles sont appliquées des tensions de déviation du faisceau d'ions (8) suivant l'angle prédéterminé et des tensions de balayage du faisceau ionique (8) simultanément dans les directions X et Y, à un état superposé, et en ce que le second déflecteur électrostatique multipolaire (6) comprend le même nombre d'électrodes (6a à 6h) que le premier déflecteur électrostatique multipolaire (5), ces électrodes étant régulièrement espacées autour du second axe optique, et étant chacune telles que des tensions de balayage du faisceau ionique (8) dans les directions X et Y lui sont appliquées, si bien que le faisceau d'ions (8) dirigé vers un substrat (7) a toujours une direction et un angle constants par rapport au substrat (7).

3. Appareil d'implantation d'ions selon la revendication 1 ou 2, caractérisé en ce que chacun des premier et second déflecteurs électrostatiques multipolaires (5, 6) est un déflecteur électrostatique à huit pôles.

4. Appareil d'implantation d'ions selon l'une quelconque des revendications 1 à 3, caractérisé par un dispositif d'application de tensions communes de balayage aux électrodes (5a à 5h, 6a à 6h) du premier et du second déflecteur électrostatique multipolaire (5, 6).

5. Appareil d'implantation d'ions selon l'une quelconque des revendications 1 à 3, caractérisé par un dispositif destiné à transmettre les tensions de balayage à appliquer aux électrodes (5a à 5h, 6a à 6h) du premier et du second déflecteur électrostatique multipolaire (5, 6) par superposition des tensions de balayage aux tensions de déviation de décalage par couplage de condensateurs destinés au premier déflecteur électrostatique multipolaire (5), et par transmission des mêmes tensions de balayage directement aux électrodes (6a à 6h) du second déflecteur électrostatique multipolaire (6).

6. Appareil d'implantation d'ions selon l'une quelconque des revendications 1 à 3, caractérisé par un dispositif destiné à transmettre les tensions de balayage à appliquer aux électrodes (5a à 5h) du premier déflecteur électrostatique multipolaire (5) par addition des tensions du signal de balayage aux tensions de signal de déviation de décalage et par amplification des tensions de signaux synthétisés ayant le même gain aux tensions, et un dispositif destiné à transmettre les tensions de balayage à appliquer aux électrodes (6a à 6h) du second déflecteur électrostatique multipolaire (6) par amplification des mêmes tensions de signaux de balayage avec le même gain en tension.

# FIG. I

# F I G. 2

# F I G. 3

# FIG. 4

# FIG. 5

$$\phi = -V\sin\theta - U\cos\theta$$

# FIG. 6

# FIG. 7

# F I G. 8

# FIG. 9

# FIG. 10

# FIG. II

# FIG. 12

# FIG. 13

# FIG. 14